# EUROPÄISCHE PATENTSCHRIFT

(11) **EP 0 856 143 B1**
(45) Veröffentlichungstag und Bekanntmachung des Hinweises auf die Patenterteilung: **11.10.2000**
(21) Anmeldenummer: 96945505.4
(22) Anmeldetag: 17.10.1996
(51) Int. Cl.: G01C 19/56

(54) **VERFAHREN ZUR HERSTELLUNG EINES CORIOLIS-DREHRATENSENSORS**
PROCESS FOR PRODUCING A SPEED OF ROTATION CORIOLIS SENSOR
PROCEDE DE FABRICATION D'UN CAPTEUR DE VITESSES DE ROTATION A EFFET DE CORIOLIS

(30) Priorität: 20.10.1995 DE 19539049
(43) Veröffentlichungstag der Anmeldung: 05.08.1998
(73) Patentinhaber: ROBERT BOSCH GMBH, 70442 Stuttgart (DE)
(72) Erfinder: MUENZEL, Horst, D-72770 Reutlingen (DE); LÄRMER, Franz, D-70437 Stuttgart (DE); OFFENBERG, Michael, D-72076 Tübingen (DE); SCHILP, Andrea, D-73525 Schwäbisch Gmünd (DE); LUTZ, Markus, D-72762 Reutlingen (DE)
(86) Internationale Anmeldenummer: DE9601969
(87) Internationale Veröffentlichungsnummer: WO9715066

(56) Entgegenhaltungen:
- EP-A- 0 618 450
- EP-A- 0 664 438

## Beschreibung

Die Erfindung betrifft ein Verfahren zur Herstellung eines Coriolis-Drehratensensors, nach dem Oberbegriff des Anspruchs 1.

### Stand der Technik

Als Coriolis-Drehratensensoren ausgebildete Sensoren sind an sich bekannt. Diese weisen federnd an einem Substrat aufgehängte, auslenkbare Schwingmassen auf, die Auswertemittel zum Erfassen von Coriolisbeschleunigungen tragen. Solche Drehratensensoren sind aus EP-A-0 664 438 und EP-A-0 618 450 bekannt.

Es ist bekannt, derartige Coriolis-Drehratensensoren mittels Plasmaätzen der Trägerstruktur (Resonator) aus einer zuvor durch zeitkontrolliertes Rückseiten-Naßätzen hergestellten Bulk-Siliciummembran zu strukturieren. Hierbei ist nachteilig, daß durch das zeitkontrollierte Naßätzen der Membran exakte Verfahrensbedingungen eingehalten werden müssen, da ansonsten die Membrandicke und damit die Strukturhöhen, also auch die für den Plasmaätzvorgang benötigten Ätzzeiten zum Durchätzen von der Vorderseite nicht kontrolliert werden können.

### Vorteile der Erfindung

Das erfindungsgemäße Verfahren mit den im Anspruch 1 genannten Merkmalen bietet demgegenüber den Vorteil, daß die schwingungsfähigen Trägerstrukturen, die die Beschleunigungssensoren zur Messung der Coriolisbeschleunigung tragen, einfach und genau strukturiert werden können. Dadurch, daß die schwingende Trägerstruktur, die die Auswertemittel sowie die Antriebsmittel trägt mittels Plasmaätzens aus einem Silicon-on-Insulator (SOI)-Wafersubstrat strukturiert werden, ist es vorteilhaft möglich, die Strukturierung weitgehend unabhängig von Ätzzeiten vorzunehmen. Der Ätzvorgang stoppt, sowohl der Naßätzschritt von der Wafer-Rückseite als auch der Plasmaätzschritt von der Wafervorderseite, automatisch am Buried Oxide, so daß die eingestellten Strukturhöhen ausschließlich von der Dicke der SOI-Schicht bestimmt werden. Hiermit wird es möglich, ein sogenanntes Überätzen durchzuführen, das heißt, der jeweilige Ätzvorgang kann für einen längeren Zeitraum als an sich notwendig wäre, durchgeführt werden, so daß insgesamt die Prozeßsicherheit bei der Strukturierung erhöht wird. Das Buried-Oxid gewährleistet neben der Stoppfunktion für die Ätzprozesse gleichzeitig einen Schutz der Strukturunterseiten während des Plasmaätzprozesses. Ansonsten würden nach dem Durchätzen der Membranfenster im Plasma durch Ätzgase (Fluorradikale), die um die Kanten herumgreifen, die Strukturunterseiten attakkiert. Insbesondere wird es somit vorteilhaft möglich, auf dem Wafersubstrat zuerst die Wafervorderseite im Plasma fertig zu strukturieren, so daß während der Herstellung bis zuletzt ein stabiler Wafer erhalten bleibt. Die Erzeugunc der Membranen kann sehr vorteilhaft erst anschließend - als letzter Schritt - mittels eines Naß- oder Trockenätzvorgangs von der Waferrückseite erfolgen, wobei das Buried Oxid - wie erwähnt - eine Abdichtung zur bereits fertig strukturierten Wafervorderseite übernimmt. Mittels des Buried Oxids erfolgt quasi eine Abdichtung der Wafervorderseite zur Waferrückseite, was durch eine zusätzliche Vorderseitenbelackung noch unterstützt werden kann.

Sehr vorteilhaft ist weiterhin, daß das Buried Oxid während der Opferschichtätzung der Coriolisbeschleunigungsaufnehmer auf den Trägerstrukturen ohne zusätzlichen Aufwand sehr leicht entfernt werden kann.

In bevorzugter Ausgestaltung der Erfindung ist vorgesehen, daß gleichzeitig mit den schwingenden Trägermassen, die die Coriolisbeschleunigungssensoren tragen, an diese integrierte Überlastanschläge strukturiert werden. Die integrierten Überlastanschläge lassen sich sehr vorteilhaft gemeinsam mit den Schwingmassen und deren Federn, mittels des Plasmaätzprozesses von der Wafervorderseite aus dem SOI-Wafersubstrat herausstrukturieren, ohne daß aufwendige Zusatzmaßnahmen zur Ausbildung externer Überlastanschläge erforderlich sind. Insgesamt läßt sich somit mittels eines Plasmatiefenätzprozesses von der Wafervorderseite eine sehr kompakte Trägerstruktur für einen Drehratensensor mit integrierten Überlastanschlägen in einfacher Weise strukturieren.

Weitere vorteilhafte Ausgestaltungen der Erfindung ergeben sich aus den übrigen in den Unteransprüchen genannten Merkmalen.

### Zeichnungen

Die Erfindung wird nachfolgend in Ausführungsbeispielen anhand der zugehörigen Zeichnungen näher erläutert. Es zeigen:
- Figur 1: eine schematische Draufsicht auf eine Trägerstruktur eines Drehratensensor;
- Figur 2: eine Schnittdarstellung durch den Drehratensensor gemäß Figur 1;
- Figur 3a und 3b: die Schaffung von Strukturen des Drehratensensors nach einer ersten Ausführungsvariante;
- Figur 4a und 4b: die Schaffung von Strukturen des Drehratensensors nach einer zweiten Ausführungsvariante;
- Figur 5a und 5b: optionale zusätzliche Verfahrensschritte zur Schaffung der Strukturen;
- Figur 6a und 6b: optionale zusätzliche Verfahrensschritte zur Schaffung der Strukturen nach einer weiteren Ausführungsvariante;
- Figur 7: eine schematische Draufsicht auf eine Trägerstruktur eines Drehratensensors nach einer weiteren Ausführungsvariante und
- Figur 8: eine Teilschnittdarstellung durch den Drehratensensor gemäß Figur 7.

### Beschreibung der Ausführungsbeispiele

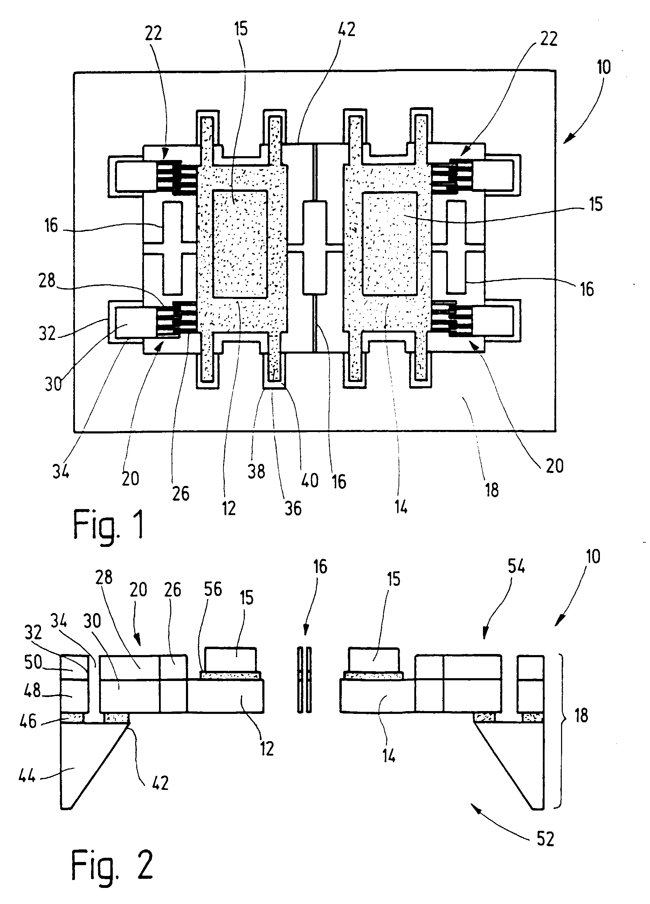

Figur 1 zeigt eine Draufsicht auf einen Drehratensensor 10. Der Drehratensensor 10 weist zwei Schwingmassen 12 beziehungsweise 14 auf. Die Schwingmassen 12 und 14 sind über Federn 16 mit einer Basis (Substrat) 18 verbunden. Die Federn 16 weisen ein hohes Aspektverhältnis auf, das heißt, ihre Höhe ist im Verhältnis zu ihrer Dicke möglichst groß. Die Federn 16 sind somit in einer planaren Schwingungsebene weich und senkrecht zur planaren Schwingungsebene steif ausgebildet. Die Schwingmassen 12 und 14, die gleichzeitig Beschleunigungssensoren 15 zum Beschleunigungsnachweis tragen, sind somit in der planaren Schwingungsebene weich und senkrecht zur planaren Schwingebene steif aufgehängt. Den Schwingmassen 12 und 14 können jeweils Kammstrukturen 20 beziehungsweise 22 für einen elektrostatischen Schwingungsantrieb zugeordnet sein. Es sind aber auch andere Antriebe denkbar. Die Kammstrukturen 20 und 22 besitzen jeweils einen fest mit den Schwingmassen 12 beziehungsweise 14 verbundenen Kamm 26 sowie einen mit dem Kamm 26 in Eingriff stehenden, mit der Basis 18 verbundenen Kamm 28. Der Kamm 28 ist an einem Sockel 30 befestigt, der in einer Ausnehmung 32 der Basis 18 angeordnet ist. Durch die Anordnung des Sockels 30 in der Ausnehmung 32 wird dieser von einer grabenförmigen Struktur 34 umgeben und lateral elektrisch isoliert; die vertikale Isolation übernimmt das vergrabene Oxid des SOI-Waferaufbaus.

Die Schwingmassen 12 und 14 weisen ferner an ihren Stirnseiten fingerförmig ausgebildete Vorsprünge 36 auf, die in Ausnehmungen 38 der Basis 18 eingreifen. Die in die Ausnehmungen 38 eingreifenden Vorsprünge 36 werden von einer grabenförmigen Struktur 40 umgeben. Wie noch erläutert wird, besitzen die Sockel 30 an ihrer Unterseite eine feste, elektrisch isolierende Verbindung zu der Basis 18, während die Vorsprünge 36 nach Abschluß der Prozessierung, das heißt, der Opferoxidätzung, frei in die Ausnehmungen 38 hineinragen, also keine Verbindung mit der Basis 18 mehr besitzen. Die Ausnehmungen 32 und 38 gehen von einem Durchbruch 42 aus, innerhalb dem die Schwingmassen 12 und 14 sowie die Federn 16 angeordnet sind. Wie in der in Figur 2 gezeigten Schnittdarstellung noch deutlich wird, liegen die Oberflächen der Basis 18 sowie der Schwingmassen 12 und 14, der Kammstrukturen 20 beziehungsweise 22 und der Vorsprünge 36 in etwa auf einer planaren Ebene.

Die in Figur 1 gezeigte Trägerstruktur (Schwingmassen 12, 14 und Federn 16) dient der Erzeugung von Coriolis-Beschleunigungen, die von den zusätzlich aufgebrachten OMM(Oberflächen-Mikromechanik)-Beschleunigungssensoren 15 erfaßt werden. Mittels der Kammstrukturen 20 werden die Schwingmassen 12 und 14 durch Anlegen einer elektrischen Wechselspannung durch elektrostatische Kräfte in eine planare Schwingbewegung versetzt. Selbstverständlich sind auch andere Antriebsarten, beispielsweise elektromagnetisch durch die Lorenzkraft auf einen stromdurchflossenen Leiter im Magnetfeld, denkbar. Im Rahmen der hier vorliegenden Beschreibung soll auf die Wirkungsweise des Drehratensensors 10 nicht weiter eingegangen werden, da diese allgemein bekannt ist.

Die in die Ausnehmungen 38 eingreifenden Vorsprünge 36 dienen einer vertikalen Bewegungsbegrenzung für die Schwingmassen 12 beziehungsweise 14. Hierdurch werden untere Anschläge für die Schwingmassen 12 und 14 gebildet, die einen Überlast/Schock-Schutz bilden.

In der Figur 2 ist ein Querschnitt durch den Drehratensensor 10 gezeigt. Gleiche Teile wie in Figur 1 sind mit gleichen Bezugszeichen versehen und nicht nochmals erläutert. Anhand des Querschnitts wird der schichtförmige Aufbau des Drehratensensors 10 deutlich. Der Drehratensensor 10 weist ein Bulk-Substrat 44 auf, auf dem eine Siliciumoxidschicht (SiO₂) als unteres Buried-Oxid 46 ausgebildet ist. Auf dem Buried-Oxid 46 ist eine SOI-Schicht 48 vorgesehen, an die sich eine EpiPoly-Schicht 50 anschließt. Das Bulk-Substrat 44 weist den Durchbruch 42 auf, der von der SOI-Schicht 48 und der EpiPoly-Schicht 50 membranartig überspannt wird. Innerhalb der SOI-Schicht 48 und der EpiPoly-Schicht 50 sind die Schwingmassen 12 und 14, die Federn 16, die Kammstrukturen 20 und 22, die Sockel 30, die Vorsprünge 36 sowie die Ausnehmungen 32 und 38 strukturiert. Die Grenze zwischen dem Bulk-Substrat 44 und den Strukturelementen des Drehratensensors 10 wird von dem unteren Buried-Oxid 46 gebildet. Durch das untere Buried-Oxid 46 wird der Drehratensensor 10 in eine Waferrückseite 52 und eine Wafervorderseite 54 aufgeteilt. Die Schwingmassen 12 und 14 und die Federn 16 können aus der relativ dicken SOI-Schicht 48 bestehen, auf die eine obere Siliciumoxid-Schicht als oberes Buried-Oxid 56 strukturiert ist. Auf dem oberen Buried-Oxid 56 sind die Beschleunigungsaufnehmer 15 in EpiPoly-Technik aufgebracht. Somit werden die Schwingmassen 12 und 14 von einer Trägerstruktur aus der SOI-Schicht 48 und den darauf angeordneten Beschleunigungsaufnehmern 15 gebildet.

Nach einer weiteren Ausführungsvariante können anstelle der Ausbildung der Beschleunigungsaufnehmer 15 aus EpiPoly diese ebenfalls in der SOI-Technik (SOI²-Ansatz) strukturiert werden. Die Buried-Oxid-Schichten 46 beziehungsweise 56 können in allgemein bekannter Weise mittels einer thermischen Oxidation und darauffolgenden Bond- und Schleif- oder Bond- und Rückätzprozessen erzeugt werden.

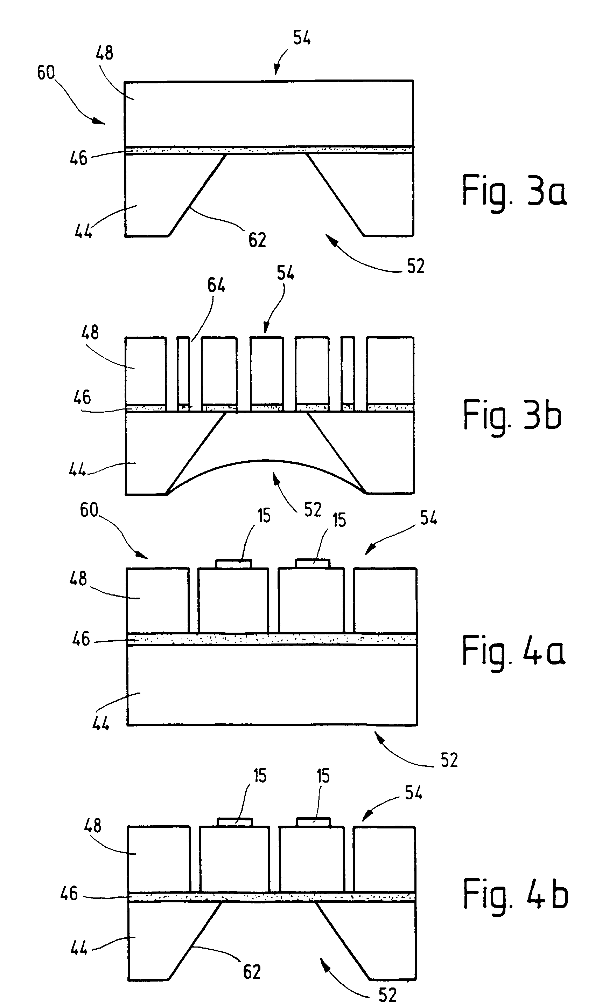

Anhand der Figuren 3a und 3b wird die Herstellung des Drehratensensors 10 in einem ersten Ausführungsbeispiel erläutert. Gemäß Figur 3a wird von einem SOI-Wafer 60 mit einer Buried-Oxid-Schicht 46 ausgegangen. Von der Waferrückseite 52 erfolgt ein naßchemisches Ätzen. Das Naß-Ätzmedium (Kalilauge) wird über eine hier nicht dargestellte Maske an die Waferrückseite 52 herangeführt, so daß sich aufgrund der Kristallstruktur des Siliciumwafers 60 die V-förmige Öffnung 62 ergibt. Das Buried-Oxid 46 ist gegenüber dem verwendeten Ätzmedium (heiße Lauge) resistent und dient somit als Ätzstopp für den NaßÄtzvorgang. Durch die Ausbildung dieses definierten Ätzstoppes für den Naßätzvorgang wird erreicht, daß die an der Wafervorderseite 54 verbleibende Membran (SOI-Schicht 48), in der später die Trägerstruktur des Drehratensensors 10 strukturiert wird, eine definierte Dicke besitzt, die ausschließlich von der Dicke der SOI-Schicht 48 bestimmt wird. Die Dicke der Schicht 48 ist somit unabhängig von der Ätzzeit, mit der das Ätzen der Öffnung 62 von der Waferrückseite 52 erfolgt. Durch das Buried-Oxid 46 wird gleichzeitig eine Schutzschicht für die Wafervorderseite 54 vor den Ätzmedien, beispielsweise KOH, Flußsäure + HNO₃ oder Plasmaätzgasen TMAH (Tetramethylammoniumhydroxid) gebildet. Auf die Trägerstruktur sind noch die hier nicht dargestellten Beschleunigungssensoren 15 (Figur 2) aufgebracht.

In einem nächsten Verfahrensschritt, der in Figur 3b gezeigt ist, wird an der Wafervorderseite 54 ein anisotroper Plasmatiefenätzprozeß durchgeführt. Hierbei wird auf die Wafervorderseite 54 eine nicht dargestellte Maskierung, beispielsweise ein Photolack, aufgebracht, wobei die Maskierung der späteren Strukturierung des Drehratensensors 10 entspricht. Über die Maskierung wird also die Geometrie der Schwingmassen 12 und 14, der Kammstrukturen 20 und 22, der Sockel 30, der Vorsprünge 36, der Ausnehmungen 32 und 38 sowie der Federn 16 (Figur 1) bestimmt. Durch das ansetzende Plasmatiefenätzen werden die nicht maskierten Bereiche aus der SOI-Schicht 48 herausgetrencht. Für diesen Plasmatiefenätzprozeß von der Wafervorderseite 54 dient wiederum das Buried-Oxid 46 als Stopp. Die Buried-Oxid-Schicht 46 kann abschließend in den Bereichen in einfacher Weise entfernt werden, in denen, gemäß der in Figur 2 gezeigten Schnittdarstellung, die frei schwingenden Strukturen des Drehratensensors 10 vorgesehen sind. Insgesamt läßt sich somit in einfacher Weise ein Drehratensensor 10 strukturieren.

Gleichzeitig mit der Strukturierung des Drehratensensors 10 können die in Figur 1 dargestellten Vorsprünge 36 strukturiert werden, die einen Überlast/Schock-Schutz für den Drehratensensor 10 bilden. Durch eine entsprechende Ausbildung der Maske während des Plasmatiefenätzprozesses werden die grabenförmigen Strukturen 40 (Figur 1) mit herausgeätzt, so daß die Vorsprünge 36 entstehen, wobei diese einstückig mit den Schwingmassen 12 beziehungsweise 14 ausgebildet sind. Die Vorsprünge 36 können somit ohne aufwendige Zusatzmaßnahmen aus dem bereits vorhandenen Aufbau des Wafers 60 erhalten werden. Da die Vorsprünge 36 mit den Schwingmassen 12 beziehungsweise 14 mitschwingen, dürfen diese keine Verbindung zu dem Bulk-Substrat 44 aufweisen. Hierzu muß später eine Freilegung, das heißt, eine Ablösung der Vorsprünge 36 von dem Bulk-Substrat 44 durch Unterätzen des Buried-Oxid 46 im Bereich der Vorsprünge 36 erfolgen. Dies geschieht ebenfalls ohne zusätzlicher. Aufwand während der Opferoxidätzung der OMM-Beschleunigungsaufnehmer 15. Je nach Dicke der Buried-Oxid-Schicht 46 kann hier eine Distanz von ca. 1 bis 3 µm geschaffen werden. Dies wird im allgemeinen genügen, um ein freies Schwingen der Trägerstruktur 12, 14 zu erlauben.

In einer anderen, anhand der Figuren 4a und 4b verdeutlichten Ausführungsvariante der Erfindung wird es vorteilhaft möglich, den Ätzprozeß von der Waferrückseite 52 erst nach Abschluß der vollständigen Prozessierung der Wafervorderseite 54 durchzuführen. Dies hat den Vorteil, daß für die Prozessierung der Wafervorderseite 54 ein insgesamt stabiler Wafer 60 ohne rückseitige Ätzöffnungen zur Verfügung steht, der in seiner Stabilität noch nicht durch die Öffnung 62 beeinflußt ist. Hinsichtlich der Einzelheiten der Vorderseitenprozeßierung und des Ätzens von der Rückseite wird auf das vorhergehende Ausführungsbeispiel verwiesen. Das Verbleiben der Buried-Oxid-Schicht 46 unter den auf der Wafervorderseite 54 geschaffenen Strukturen gewährleistet gleichzeitig einen sehr guten Schutz gegenüber dem Ätzangriff von der Wafer-rückseite 52.

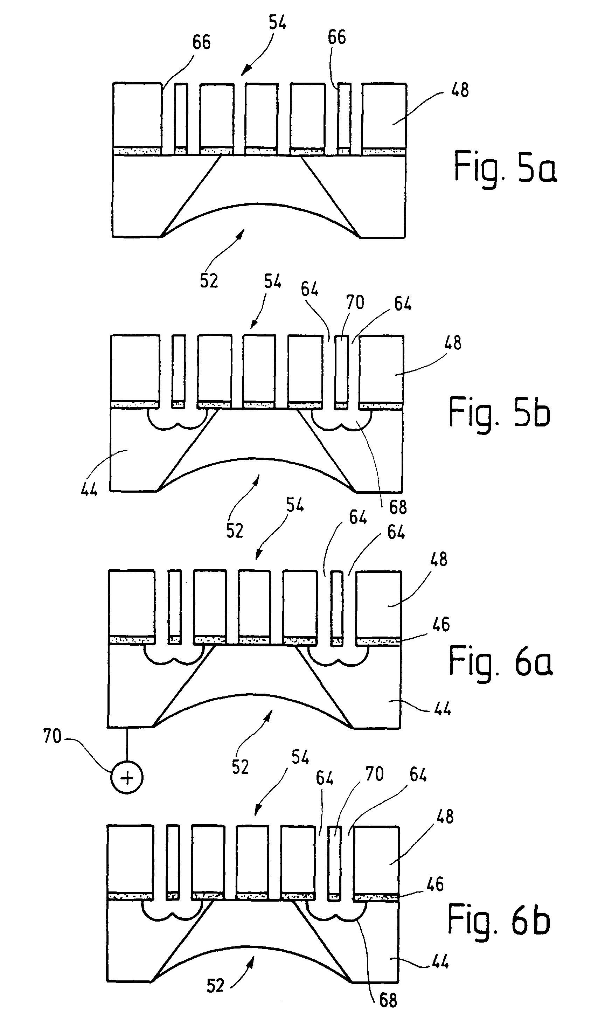

Sollte dies Distanz zwischen der Buried-Oxid-Schicht 46 und der geschaffenen Trägerstruktur in bestimmten Anwendungsfällen nicht ausreichen, kann gemäß der Figuren 5c und 5b der Abstand zwischen den Vorsprüngen 36 und dem Bulk-Substrat 44 durch ein isotropes Plasma-Unterätzen der Vorsprünge 36 im Bulk-Substrat 44 vergrößert werden. Hierbei werden die Seitenwände der geschaffenen Trenchgräben 64, in diesem speziellen Fall der die später die grabenförmigen Struktur 40 ergebenden Trenchgräben 64, gegenüber einem isotrop angreifenden Plasmamedium passiviert. Hierzu können die Seitenwände beispielsweise mit einem teflonartigen Plasmafilm 66 versehen werden. Anschließend erfolgt das isotrope Plasmaunterätzen im Bulk-Substrat 44, so daß dort Freiräume 68 entstehen. Die Freiräume 68 verbinden hierbei jeweils zwei benachbarte Trenchgräben 64, so daß der zwischen den Trenchgräben 64 verbleibende Bereich 70, im gewählten Beispiel also die Vorsprünge 36, keinen Berührungskontakt mehr mit dem Bulk-Substrat 44 besitzen.

Nach einer weiteren Ausführungsvariante kann gemäß der in Figur 6a und 6b verdeutlichten Verfahrensschritte nach dem Plasmatiefenätzen der Trenchgräben 64 und das Entfernen des Buried-Oxids 46 am Grund der Trenchgräben 64 an das Bulk-Substrat 44 eine anodische Spannung 70 angelegt werden. Die freigelegte Oberfläche des Bulk-Substrats 44 in den Trenchgräben 64 wird mit einem Elektrolyten 72, beispielsweise wäßriger Flußsäure und Isopropanol beaufschlagt. Hierdurch erfolgt ein elektrochemisches Auflösen von Bereichen des Bulk-Substrats 44, die ebenfalls zur Ausbildung der Freiräume 68 (Figur 4b) führen. Die auf der Wafervorderseite 54, die geschaffenen Strukturen aufweisende SOI-Schicht 48 wird hierbei vor dem elektrochemischen Zersetzen bewahrt, da diese über das Buried-Oxid 46 von dem anodischen Potential 70 elektrisch isoliert ist.

Insgesamt ergibt sich somit die Möglichkeit, mittels eines einfach beherrschbaren Plasmatiefenätzprozesses in der SOI-Schicht 48 einen Drehratensensor 10 zu strukturieren, der einen effizienten elektrostatischen Kammantrieb 20, 22 zur Anregung der planaren Schwingungsbewegung der Schwingmassen 12 und 14 beziehungsweise einen kapazitiven Kammabgriff 15 zur Detektion der Schwingungsbewegung aufweist. Selbstverständlich sind auch andere Antriebsarten, beispielsweise elektromagnetisch über die Lorentzkraft auf eine Leiterschleife im äußeren Magnetfeld, denkbar. Durch das Buried-Oxid 46 ist eine hochwertige dielektrische Isolation der Strukturen gegeneinander gegeben. Die laterale Isolation wird in einfacher Weise durch das Tiefentrenchen der grabenförmigen Strukturen 32 um die Sockel 30 herum erreicht. Die Sockel 30 werden bei der Opferoxidätzung nicht abgeätzt, da diese größere Dimensionen aufweisen.

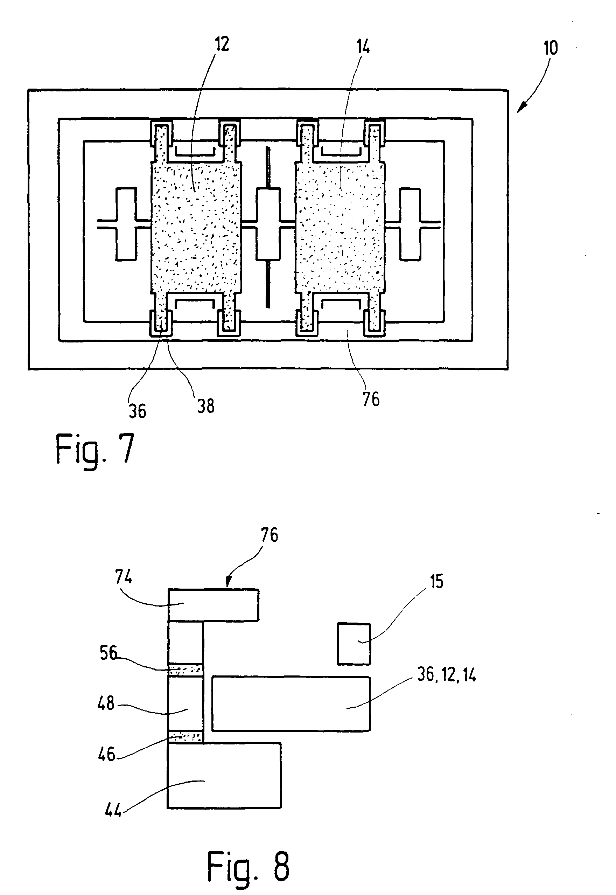

In den Figuren 7 und 8 ist ein weiteres Ausführungsbeispiel eines Drehratensensors 10 gezeigt, wobei gleiche Teile wie in den vorhergehenden Figuren mit gleichen Bezugszeichen versehen und nicht nochmals erläutert sind. Zusätzlich zu der Ausbildung des unteren Anschlages gegen Überlast/Schock des Beschleunigungssensors 10 durch das Eingreifen der Vorsprünge 36 in die Ausnehmungen 38 ist hier ein oberer Anschlag 74 vorgesehen, der die Vorsprünge 36 übergreift. Der obere Anschlag 74 wird erzielt, indem die Vorsprünge 36 bis zum oberen Buried-Oxid 56 (Figur 6) abgeätzt werden. Dieses Abätzen kann sehr vorteilhaft gleichzeitig mit dem Plasmatiefenätzprozeß zur Ausbildung der Strukturen der oberen Beschleunigungssensoren 15 (Trenchgräben 64 cemäß Figur 3 und 4) erfolgen und erfordert keinen zusätzlichen Prozeßschritt.

Das Buried-Oxid kann im Fall von oberem EpiPoly vor Abscheidung der dicken Polyschicht entweder geeignet vorstrukturiert werden, oder es wird während des Tieftrenchprozesses zur Ätzung der schwingenden Trägerstruktur durch Wechsel der Ätzplasmachemie zu einer Oxidätzchemie durchgeätzt, was speziell beim SOI²-Prozeß vorteilhaft ist. Es entsteht so zwischen Oberfläche Vorsprung 36 (=unteres SOI) und Oberfläche des umgebenden Festland-Siliciums (Basis 18)(=EpiPoly oder oberes SOI) eine Höhendifferenz von der Dicke der oberen EpiPoly- oder SOI-Schicht, zum Beispiel 12 µm. Dann werden durch Aufbringen eines Festresists brückenförmige Anschläge 74 so über den Vorsprüngen 36 erzeugt, daß diese bei Auslenkung nach oben um die Dicke der oberen EpiPoly- oder SOI-Schicht an der Unterseite der Anschläge 74 anschlagen. Der Festresist kann entweder vor dem Laminieren photolithographisch vorstrukturiert und danach justiert aufgebracht werden, oder die Aufbringung und anschließende Photolithographie des Festresists geschieht ganzflächig vor der Opferschichtätzung der OMM-Sensorstrukturen, wo eine Naßentwicklung auf dem Wafer noch zulässig ist.

Die Anschläge 74 lassen sich beispielsweise dergestalt erzeugen, daß ein geschlossener Festresistrahmen 76 die gesamte Sensorstruktur umschließt, wie dies die Abbildung 5 schematisch darstellt.

Nach einem anderen, nicht dargestellten Ausführungsbeispiel, ist es auch möglich, eine Kappe so auf die Basis 18 aufzubringen, beispielsweise durch Kleben oder Löten, daß der Kappenrand die Anschläge 36 so überdeckt, daß die entsprechende Anschlagwirkung entsteht. Der Kappenrand entspricht damit sinngemäß dem überlappenden Festresistrahmen 74, 76.

## Patentansprüche

1. Verfahren zur Herstellung eines Drehsensors, welcher federnd an einem Substrat aufgehängte, auslenkbare Schwingmassen, die Auswertemittel zum Erfassen von Coriolis-Beschleunigungen tragen, sowie Antriebsmittel zur Anregung einer planaren Schwingung der Schwingmassen aufweist, gekennzeichnet durch folgende Schritte:
- Strukturieren
- einer aus den Schwingmassen (12, 14) und den Federn (16) bestehende Trägerstruktur für die Auswertemittel (15),
- sowie von Antriebsmitteln (20)
in die Oberseite (54) eines eine Buried-Oxid-Schicht (46) beinhaltenden Silicon-on-Insulator (SOI) - Wafers (60) in einem gemeinsamen Arbeitsgang mittels Plasmaätzen,
- Erzeugen eines Durchbruches (42) durch das die Rückseite des Wafers bildende Bulk-Substrat (44) unterhalb der schwingenden Strukturen (12, 14, 16, 20) durch Naßätzen,
- Entfernen der Buried-Oxid-Schicht (46) unter den schwingenden Strukturen (12, 14, 16, 20).

2. Verfahren nach Anspruch 1, **dadurch gekennzeichnet,** daß die Buried-Oxid-Schicht (46) als Ätzstopp für das vorderseitige Plasmaätzen und das rückseitige Ätzen dient.

3. Verfahren nach einem der vorhergehenden Ansprüche, **dadurch gekennzeichnet,** daß die Buried-Oxid-Schicht (46) gleichzeitig als Ätzstopp für einen Ätzprozeß zur Erzeugung einer SOI-Membranschicht (48) in dem Wafer (60) von der Waferrückseite (52) dient.

4. Verfahren nach Anspruch 3, **dadurch gekennzeichnet,** daß die Freilegung der SOI-Membranschicht (48) mit den Strukturen (12, 14, 16, 20, 22, 36) des Drehratensensors (10) durch das naßchemische Ätzen von der Waferrückseite (52) nach Abschluß der Strukturierung des Drehratensensors (10) von der Wafervorderseite (54) erfolgt.

5. Verfahren nach einem der Ansprüche 3 und 4, **dadurch gekennzeichnet,** daß die Drehratensensor-Trägerstruktur (10) in der SOI-Membranschicht (48) strukturiert wird.

6. Verfahren nach einem der vorhergehenden Ansprüche, **dadurch gekennzeichnet,** daß gleichzeitig mit den Schwingmassen (12, 14) Überlastanschläge für die Drehratensensor-Trägerstruktur (10) strukturiert werden.

7. Verfahren nach Anspruch 6, **dadurch gekennzeichnet,** daß zur Ausbildung der Überlastanschläge grabenförmige Strukturen (40) um Vorsprünge (36) strukturiert werden, und daß das Buried-Oxid (46) unter den Vorsprüngen (36) in einem späteren Prozeßschritt als Opferoxid entfernt wird.

8. Verfahren nach Anspruch 7, **dadurch gekennzeichnet,** daß ein Bulk-Substrat (44) unter den Vorsprüngen (36) zur Ausbildung von Freiräumen (68), bei geschützter Seitenwand, beispielsweise teflonbeschichteter Seitenwand, isotrop plasmaunterätzt wird, um den Abstand der Vorsprünge (36) von der Basis (18) und damit die vertikale Beweglichkeit der Schwingmassen (12, 14) zu vergrößern.

9. Verfahren nach Anspruch 8, **dadurch gekennzeichnet,** daß das Bulk-Substrat (44) unter den Vorsprügen (36) zur Ausbildung der Freiräume (68) elektrochemisch angeätzt wird, und Freiräume für eine vertikale Beweglichkeit damit vergrößert werden.

10. Verfahren nach einem der Ansprüche 6-9, **dadurch gekennzeichnet,** daß zusätzlich zu den unteren Anschlägen obere Anschläge für die seismischen Massen (12, 14) erzeugt werden.

11. Verfahren nach Anspruch 10, **dadurch gekennzeichnet,** daß über die Vorsprünge (36) brückenförmige Anschläge (74) strukturiert werden.

12. Verfahren nach Anspruch 11, **dadurch gekennzeichnet,** daß die brückenförmigen Anschläge (74) als ein die gesamte Struktur des Drehratensensors (10) umschließender Festresistrahmen (76) ausgebildet werden.

13. Verfahren nach einem der Ansprüche 11 und 12, **dadurch gekennzeichnet,** daß eine Kappe so aufgebracht wird, daß der Kappenrand den Anschlag (74) bildet.

## Claims

1. Process for producing a rotation sensor having deflectable oscillatory masses which are suspended resiliently from a substrate and carry evaluation means for detecting Coriolis accelerations, and having drive means for exciting a planar oscillation of the oscillatory masses, characterized by the following steps:
- structuring
- of a carrier structure for the evaluation means (15), the said carrier structure comprising the oscillatory masses (12, 14) and the springs (16),
- and also of drive means (20)
into the top side (54) of a silicon-on-insulator (SOI) wafer (60), comprising a buried oxide layer (46), in a common work operation by means of plasma etching,
- production of a perforation (42) through the bulk substrates (44), forming the rear side of the wafer, underneath the oscillating structures (12, 14, 16, 20) by wet etching,
- removal of the buried oxide layer (46) below the oscillating structures (12, 14, 16, 20).

2. Process according to claim 1, characterized in that the buried oxide layer (46) serves as an etching stop for the plasma etching on the front side and the etching on the rear side.

3. Process according to one of the preceding claims, characterized in that the buried oxide layer (46) simultaneously serves as an etching stop for an etching process for producing an SOI diaphragm layer (48) in the wafer (60) from the rear side (52) of the wafer.

4. Process according to claim 3, characterized in that the uncovering of the SOI diaphragm layer (48) with the structures (12, 14, 16, 20, 22, 36) of the rate-of-rotation sensor (10) by the wet-chemical etching from the rear side (52) of the wafer is effected after the conclusion of the structuring of the rate-of-rotation sensor (10) from the front side (54) of the wafer.

5. Process according to one of claims 3 and 4, characterized in that the rate-of-rotation sensor carrier structure (10) is structured in the SOI diaphragm layer (48).

6. Process according to one of the preceding claims, characterized in that overload stops for the rate-of-rotation sensor carrier structure (10) are structured at the same time as the oscillatory masses (12, 14).

7. Process according to claim 6, characterized in that, in order to form the overload stops, trench-type structures (40) are structured around projections (36), and in that the buried oxide (46) below the projections (36), and in that the buried oxide (46) below the projections (36) is removed as sacrificial oxide in a later process step.

8. Process according to claim 7, characterized in that a bulk substrate (44) is undercut by isotropic plasma etching under the projections (36) for the purpose of forming free spaces (68), with a protected side wall, for example a teflon-coated side wall, in order to increase the distance between the projections (36) and the base (18) and hence the vertical mobility of the oscillatory masses (12, 14).

9. Process according to claim 8, characterized in that the bulk substrate (44) is etched electrochemically under the projections (36) for the purpose of forming the free spaces (68), and free spaces for vertical mobility are thus enlarged.

10. Process according to one of claims 6-9, characterized in that in addition to the lower stops, upper stops are produced for the seismic masses (12, 14).

11. Process according to claim 10, characterized in that bridge-type stops (74) are structured above the projections (36).

12. Process according to claim 11, characterized in that the bridge-type stops (74) are designed as a solid resist frame (76) enclosing the entire structure of the rate-of-rotation sensor (10).

13. Process according to one of claims 11 and 12, characterized in that a cap is applied in such a way that the cap edge forms the stop (74).

## Revendications

1. Procédé de fabrication d'un capteur de vitesse de rotation suspendu à un substrat et comprenant des masses oscillantes, déboîtables, portant des moyens d'exploitation pour saisir les accélérations de Coriolis ainsi que des moyens d'entraînement pour exciter une oscillation planar des masses oscillantes,
caractérisé par les étapes suivantes :
- mise en structure
* d'une structure de support formée des masses oscillantes (12, 14) et des ressorts (16) pour les moyens d'exploitation (15),
* ainsi que de moyens d'entraînement (20),
dans la face supérieure (54) d'une plaquette (60) de silicium sur isolant SOI ayant une couche d'oxyde enfouie (46) au cours d'une opération commune par attaque au plasma,
- on réalise un passage (42) à travers le substrat (44) formant la face arrière de la plaquette, sous les structures oscillantes (12, 14, 16, 20) par attaque chimique par voie humide,
- on enlève la couche d'oxyde enfouie (46) sous les structures oscillantes (12, 14, 16, 20).

2. Procédé selon la revendication 1,
caractérisé en ce que
la couche d'oxyde enfouie (46) constitue une barrière d'attaque pour l'attaque au plasma de la face avant et pour l'attaque de la face arrière.

3. Procédé selon l'une des revendications précédentes,
caractérisé en ce que
la couche d'oxyde enfouie (46) sert en même temps d'arrêt d'attaque pour un procédé d'attaque servant à générer une couche de membrane SIO (48) dans la plaquette (60) en partant de la face arrière (52) de la plaquette.

4. Procédé selon la revendication 3,
caractérisé en ce que
le dégagement de la couche formant membrane SOI (48) avec les structures (12, 14, 16, 20, 22, 36) du capteur de vitesse de rotation (10) se fait par attaque chimique par voie humide en partant de la face arrière (52) de la plaquette à la fin de la mise en structure du capteur de vitesse de rotation (10) à partir de la face avant (54) de la plaquette.

5. Procédé selon l'une des revendications 3 et 4,
caractérisé en ce que
la structure de support (10) du capteur de vitesse de rotation est réalisée dans la couche de la membrane SOI (48).

6. Procédé selon l'une quelconque des revendications précédentes,
caractérisé en ce qu'
en même temps avec les masses oscillantes (12, 14), on réalise la structure de butées de surcharge pour la structure de support de capteur de vitesse de rotation (10).

7. Procédé selon la revendication 6,
caractérisé en ce que
pour réaliser les butées de surcharge, on forme une structure de sillons (40) autour de saillies (36), et on enlève la couche d'oxyde enfouie (46) ou les parties en saillie (36) au cours d'une étape de procédé ultérieure comme oxyde sacrifié.

8. Procédé selon la revendication 7,
caractérisé en ce qu'
on réalise une attaque par en dessous du substrat en vrac (44), sous les saillies (36) pour former des dégagements (68) en cas de parois latérales protégées par exemple d'une paroi latérale revêtue de Téflon, en procédant par attaque isotrope au plasma, pour augmenter l'intervalle entre les saillies (36) et la base (18) et ainsi la mobilité verticale des masses oscillantes (12, 14).

9. Procédé selon la revendication 8,
caractérisé en ce qu'
on attaque le substrat (44) sous les saillies (36) pour former des dégagements (68) en procédant de manière électrochimique et on augmente ainsi les dégagements pour une mobilité verticale.

10. Procédé selon l'une quelconque des revendications 6 à 9,
caractérisé en ce qu'
en plus des butées inférieures, on réalise des butées supérieures pour les masses sismiques (12, 14).

11. Procédé selon la revendication 10,
caractérisé en ce qu'
on réalise des butées en forme de ponts (74) par-dessus les saillies (36) .

12. Procédé selon la revendication 11,
caractérisé en ce que
les butées en forme de ponts (74) sont réalisées comme un cadre de vernis résist, solide (76) entourant l'ensemble de la structure du capteur de vitesse de rotation (10).

13. Procédé selon l'une quelconque des revendications 11 et 12,
caractérisé en ce qu'
on applique un capuchon qui forme par son bord la butée (74).
